# EUROPEAN PATENT APPLICATION

(11) **EP 2 214 465 A2**
(43) Date of publication of application: **04.08.2010**
(21) Application number: 10000641.0
(22) Date of filing: 22.01.2010
(51) Int. Cl.: H05K 7/20, H04N 5/64

(54) **Display apparatus**

(30) Priority: 29.01.2009 JP 2009018690; 29.01.2009 JP 2009018691; 29.01.2009 JP 2009018692; 29.01.2009 JP 2009018693
(71) Applicant: SANYO Electric Co., Ltd., Moriguchi-shi Osaka 570-8677 (JP)
(72) Inventor: Nakamichi, Masaya, Moriguchi-shi Osaka (JP); Take, Nobuyuki, Moriguchi-shi Osaka (JP); Takahashi, Shohei, Moriguchi-shi Osaka (JP)
(74) Representative: Glawe, Delfs, Moll

(57) **Abstract**

The display apparatus comprises a first accommodation part; a display part arranged inside the first accommodation part, and is viewable from the front side of the first accommodation part; a second accommodation part arranged at the back side of the first accommodation part; a cooling unit arranged under the display part, which cools the display part; a circuit unit arranged inside the second accommodation part and controls the display part and a fan leading an air from the cooling unit to the circuit unit.

## Description

### CROSS REFERENCE TO THE RELATED APPLICATION

The priority application number 2009-018690, 2009-018691, 2009-018692, and 2009-018693, upon which this patent application is based is hereby incorporated by reference.

### BACKGROUND OF THE INVENTION

### 1. Field of the Invention

The present invention relates to a display system, especially, a display system for installation outdoors.

### 2. Description of Related Art

Conventionally, flat panel displays, such as liquid crystal displays (LCDs), are widely used.

Recently, it has been desired to place liquid crystal displays permanently outdoors, because the thickness of the displays are small and can display high resolution pictures. Since the thickness of the LCD display is small, it can be installed on an outer wall of a building, or in narrow places such as bus stop shelters, etc. Moreover, because the resolution of a LCD display is high, it can display a clear picture even if the screen size is small.

Therefore, in order to install liquid crystal displays outdoors, it was considered to arrange the LCD display panel or circuit boards, which are easy to be damaged by rainstorms, dusts, or snows etc., inside an accommodation space having a waterproofing structure. For a circuit board, it is considered to arrange it inside the other accommodation part so that the heat generated from the display panel does not affect the circuit board. However, the inside of the accommodation part may easily be heated because of the heat from the circuit board, which may damage the circuit board.

### SUMMARY OF THE INVENTION

A display apparatus of the present invention comprises: a first accommodation part; a display part arranged inside the first accommodation part and viewable from the front side of the first accommodation part; a second accommodation part arranged at the back side of the first accommodation part; a circuit unit arranged inside the second accommodation part; an advertisement installation part which arranges the advertisement viewable from the rear side of the display apparatus, wherein the back wall of the second accommodation part is constituted by a removable cover component.

FIG.1 is a perspective diagram showing the display system having a display apparatus.
FIG.2 is an exploded perspective view of a display system.
FIG.3 is a sectional view along the IV-IV line shown in FIG.2.
FIG.4 is a sectional view along the V-V line shown in FIG.3.
FIG.5 is a sectional view along the VI-VI line shown in FIG.3.
FIG.6 is a sectional view along the VII-VII line shown in FIG.3.
FIG.7 is a two-dimensional diagram of this display system.
FIG.8 is an enlarged view of IX area shown in FIG.4.
FIG.9 is the perspective diagram when fractured along X-X-rays shown in FIG.3.
FIG.10 is the perspective diagram when fractured along XI-XI line shown in FIG.3.
FIG.11 is a sectional view along the XI-XI line shown in FIG.3.
FIG.12 is an enlarged view of the XIII area shown in FIG.11.
FIG.13 is an enlarged view of the XIV area shown in FIG.11.
Fig.14 is a perspective diagram of the display apparatus from the back side when a cover component is attached.
Fig.15 is a perspective diagram of the display apparatus from the back side when a cover component is detached.
Fig.16 is the perspective diagram of the back wall of the first accommodation part from the back lower direction when a cover component is attached.
Fig.17 is the perspective diagram of the back wall of the first accommodation part from the back lower direction when a cover component is detached.

### DETAILED DESCRIPTION OF THE INVENTION

The present invention embodied in a display apparatus or display system will be specifically described below with the reference to the drawings.

### 1. Outline of the display system

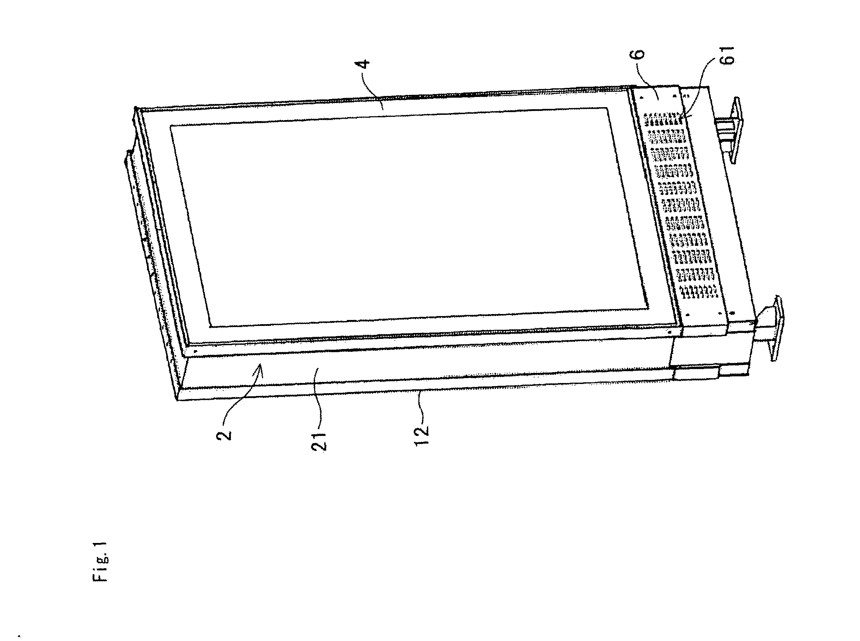

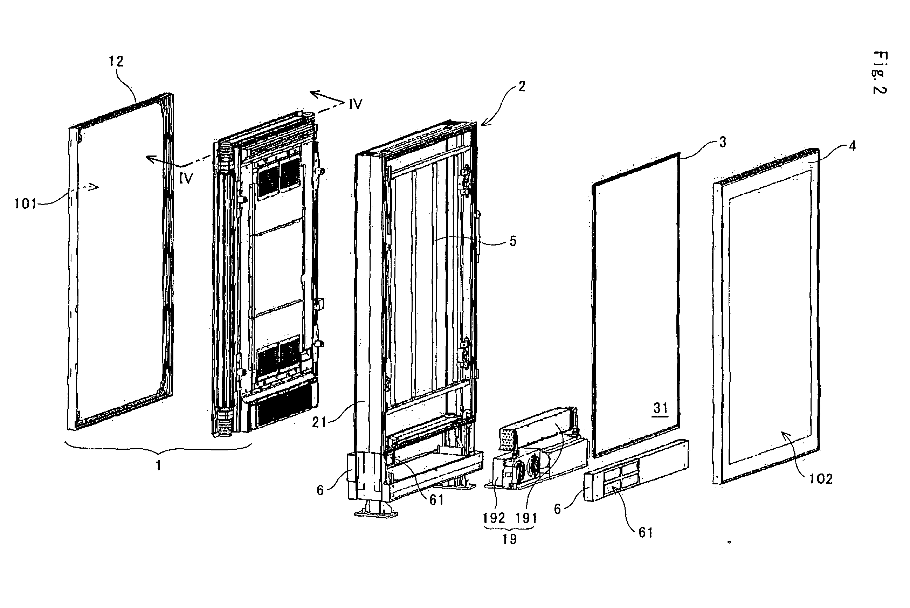

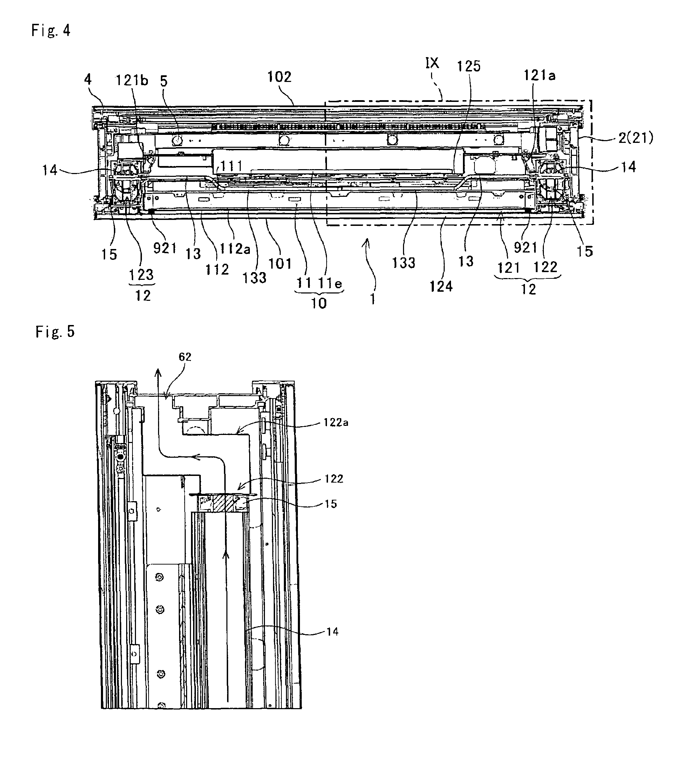

As shown in FIG.1 the display system has a flat rectangular appearance, and as shown in FIG.2, it includes a display apparatus 1, support stand 2, backboard 3, cover 4, fluorescent light fittings 5, and pair of aeration plates 6, 6. The display apparatus 1 displays an image on the surface 101 of the display system, and has a liquid crystal display 10 as shown in FIG.5. The detail of the display apparatus 1 is explained below in section 2 entitled "A display apparatus".

The support stand 2 supports the display apparatus 1 and the backboard 3, and a frame part 21 for attaching the display apparatus 1 and the backboard 3 is formed. The frame part 21 has a structure that can contain the display apparatus 1 and the backboard 3.

The backboard 3 is an installation stand for attaching an advertisement, and is installed in the frame part 21 at the back side of the display apparatus 1. The advertisement is attached on the surface 31 of the backboard 3, which is a back surface 102 of a display system. Here, the backboard 3 is formed from a material having an optical transparency in order to transmit a light emitted from the fluorescent light fittings 5. The advertisement attached to the backboard 3 is also formed from a material having an optical transparency as well. Hereafter, such advertisement is called "advertising film".

The back cover 4 is removably attached to the support stand 2, and when the cover 4 is closed, it covers the surface 31 of backboard 3 for attaching an advertisement. Thereby, the advertisement is protected.

The portion which faces the surface 31 among the covers 4 is formed with a material having an optical transparency. Thereby, the advertisement can be seen from the back side 102 of the display system.

The fluorescent light fitting 5 is an instrument which illuminates the advertising film attached on the surface 31, and is constituted by a plurality of fluorescent lights extending in the perpendicular direction. The fluorescent light fitting 5 is attached to the frame part 21 between the display apparatus 1 and the backboard 3. By illuminating an advertising film with the fluorescent light fittings 5, characters printed on the advertising film can be seen even at nighttime.

A pair of aeration plates 6, 6 are arranged at the front 101 and the back 102 of the display system respectively, at the bottom part of the display apparatus 1. A plurality of vents 61, which aerate the inside and the outside of the display system are formed in the aeration plates 6.

The display system mentioned above can be installed in a bus stop or similar waiting area of public transportation systems. According to this system, it can offer many kinds of information to the people waiting at the stop using still pictures or moving animations.

By operating a display system by remote control using a cable or a wireless communication system, information displayed on the screen 112a can be updated remotely. Furthermore, when display systems are installed in each of multiple bus stops of a transportation system, those display systems can be managed collectively.

### 2. Display apparatus

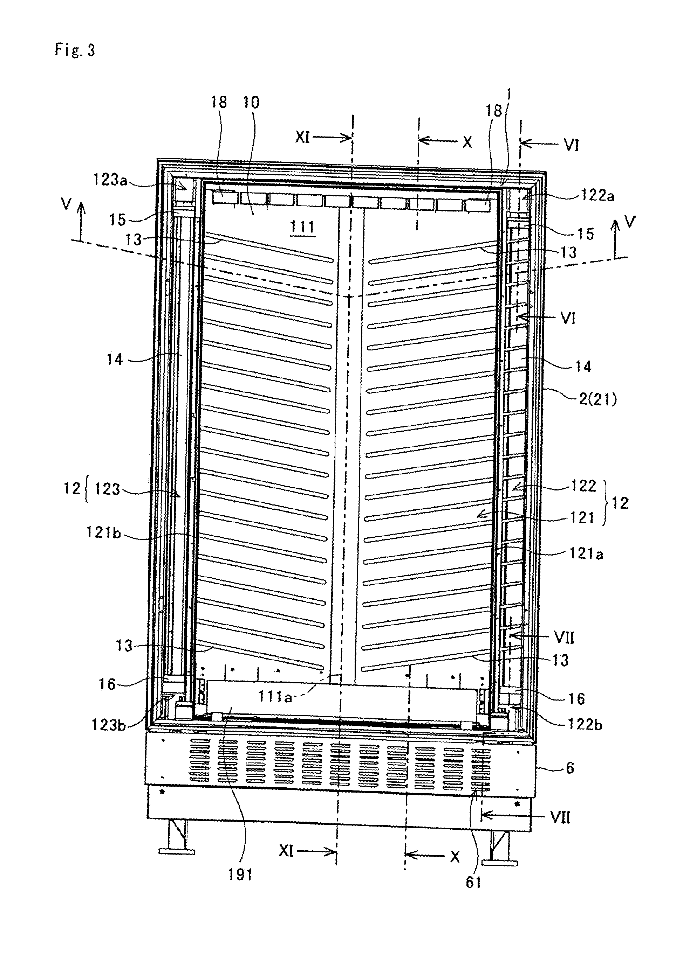

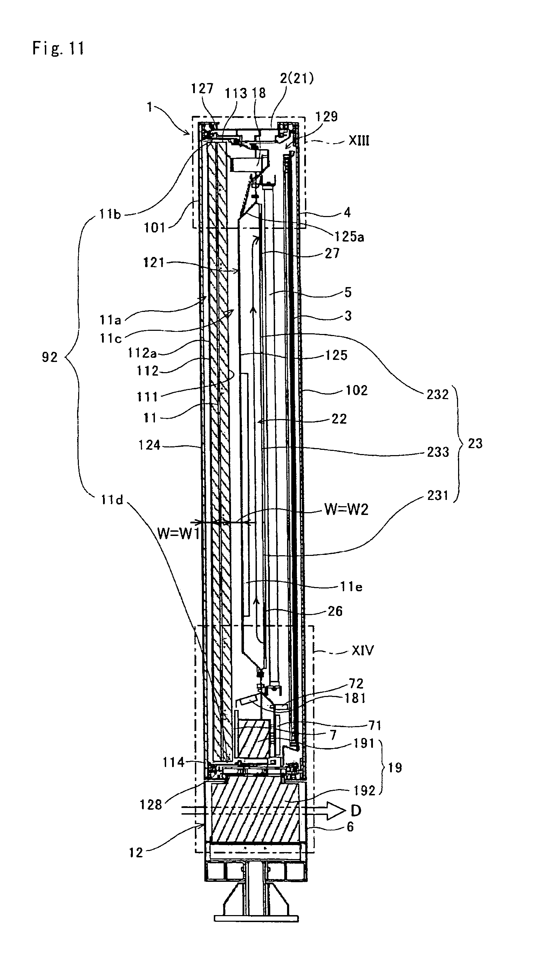

As shown in FIG.3 and FIG.4, the display apparatus 1 has a liquid crystal display 10, a housing 12 having a waterproofing structure, a plurality of heat pipes 13, a circulation fan 18, a radiating fin 14, and aeration fans 15 and 16. Furthermore, as shown in FIG.11, the display apparatus 1 also has an air conditioner 19 for cooling the liquid crystal display 10, a circulation fan 181, a heat insulator 7, heat collecting fin 71, first blowing fan 72 and second blowing fan 73.

### Liquid crystal display 10

The liquid crystal display 10 is a plane surface type display, and as shown in FIG.5, it has a display panel 11, and a circuit board 11e for controlling the display panel 11.

Depending upon its usage, various forms of display panel 11 can be used. In this embodiment, the display panel 11 has a rectangular shape extending in the vertical direction so that it can be installed in narrow places such as bus stops. Further, the display panel 11 tends have a high temperature, because it tends to generate heat especially on the surface 112 where the display screen 112a is formed.

### Housing 12

### Accommodation part

As shown in Fig.11, inside the housing 12, a first accommodation part 121 maintained sealed or substantially sealed, and the second accommodation part 22, located in the back side of the back wall 125 of the first accommodation part 121, are formed. While the display panel 11 is arranged inside the first accommodation part 121 so that the display screen 112a turns to the front side 101 of the display apparatus, the circuit board 11e is arranged inside the second accommodation part 22, in the back side of the back wall 125.

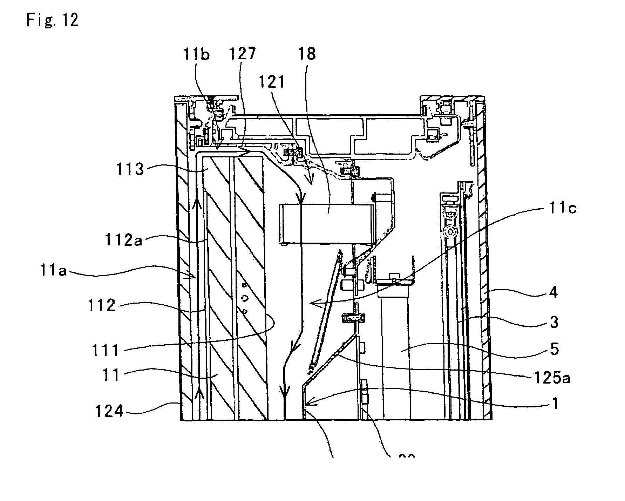

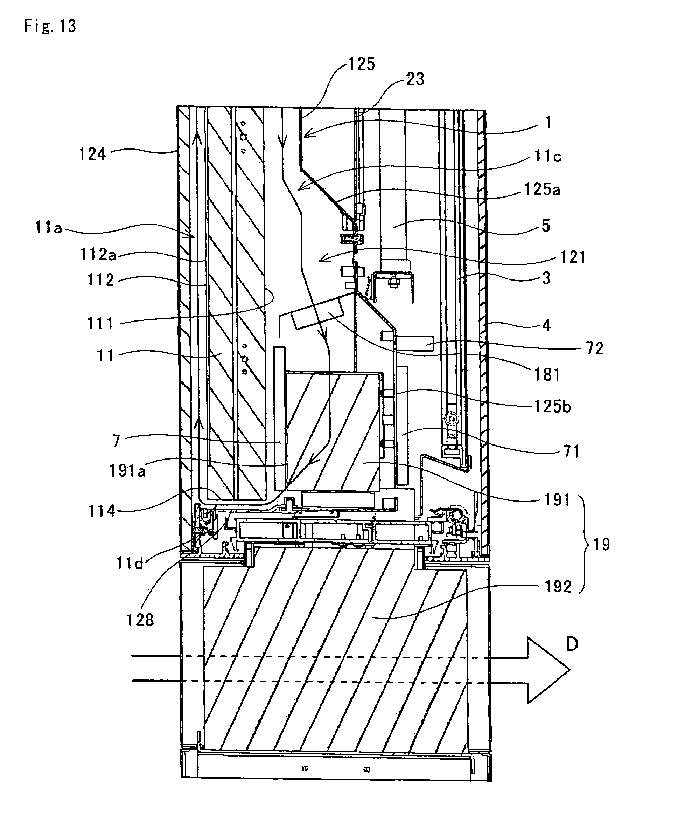

As shown in Fig.3 and Fig.11, the housing 12 has a front wall 124 on the surface 112 side of the display panel 11, a back wall 125 on the back side 111 of the panel 11, side walls 121a and 121b on the both sides of the panel 11, an upper surface wall 127 on the upper end side 113 of the panel 11 (see FIG.12 as well), and an undersurface wall 128 on the bottom side 114 of the panel 11 (see FIG.13 as well).

A portion of the front wall 124, where faces the display screen 112a is formed by a material transmitting a light (e.g. a glass material). Thereby, the display screen 112a is viewable from the front side of the housing 12.

By these front wall 124, back wall 125, side walls 121a and 121b, upper surface wall 127, and undersurface wall 128, the first accommodation part 121 is constituted maintained in a sealed or substantially sealed state,.

By maintaining the first accommodation part 121 in a sealed state, and by accommodating the display panel 11 inside the first accommodation part 121, the display panel 11 can be protected from rain, dust, debris, snow, etc. even when the display apparatus 1 is installed outdoors.

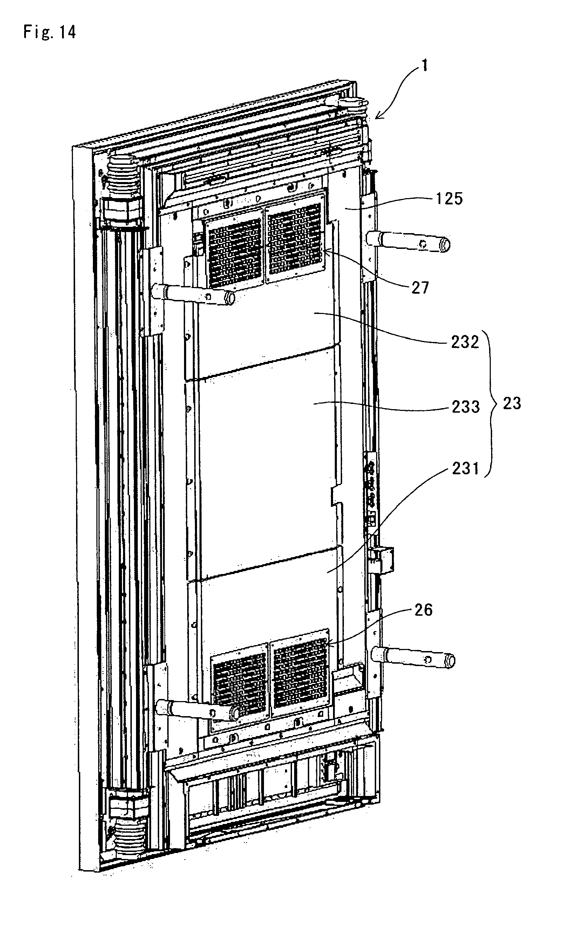

As shown in Fig.11 and Fig.14, a concave portion 125a is formed in the back of the back wall 125, and the cover component 23 covering the concave portion 125a is attached removably in front of the fluorescent light fittings 5 and the backboard 3. In the cover component 23, a pair of ventilation openings 26 and 27 is formed. The opening 26 is arranged in the lower part, and the opening 27 is arranged in the upper part.

As shown in Fig.11 and Fig.14, the cover component 23 is constituted by a lower cover 231 covering the lower part space of the concave portion 125a, the upper cover 232 covering the upper part space of the concave portion 125a, and the middle cover 233 covering the space between the upper and lower part space. Each of the covers 231, 232, 233 is removable with the back wall 125.

The ventilation opening 26 is formed in the lower cover 231 and the opening 27 is formed in the upper cover 232.

The inner wall of the concave portion 125a constitutes a front and a side wall of the second accommodation part 22. The cover component 23 attached to the back wall 125 constitutes the back wall of the second accommodation part 22.

Thus, by attaching the cover component 23, the second accommodation part 22 surrounded by the inner wall of the concave portion 125a and the cover component 23 is formed. Thereby, the circuit board 11e arranged inside the accommodation part 22 will not be exposed to rainstorms or outside air when the display apparatus 1 is installed outdoors. Moreover, by arranging the circuit board 11e inside the second accommodation part 22, separately from the first accommodation part 121 for the display panel 11, the circuit board 11e will not be affected by a heat from the display panel 11. Accordingly, the circuit board 11e is less likely to be damaged.

Further, by detaching the cover component 23, the back wall of the second accommodation part 22 is removed, and thereby the repairing or adjustment of the circuit board 11e can be done easily from back side of the case.

Further, when the concave portion 125a is covered by the cover component 23, the portion 125b (which is also a portion of the back wall 125) formed under the concave portion 125a, and the cover component 23 are aligned in the perpendicular direction, as shown in Fig.11 and Fig.13.

### Back Cover 4

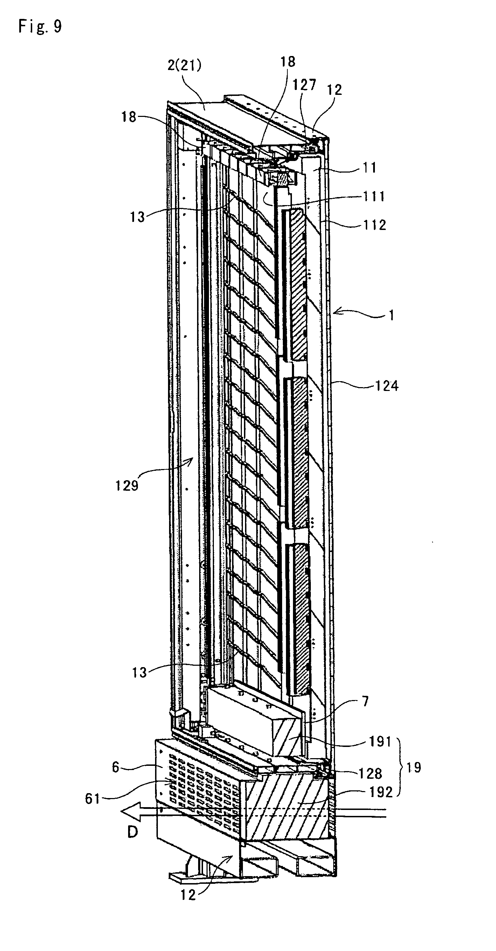

As shown in Fig.9 and Fig.11, an opening 129, which can be opened and closed by the back cover 4, is formed in the back side of the housing 12. Thereby, the advertisements installed in the backboard 3 can be easily replaced.

Although the outdoor air might intrude inside the housing 12 when the back cover 4 is opened for replacing the advertisement, display panel 11 and the circuit board 11e are less likely to be exposed to the outdoor air because they are arranged inside the accommodation parts 121 and 22. Thus, the damaging of the panel 11 and the circuit board 11e are prevented.

### Circulation path

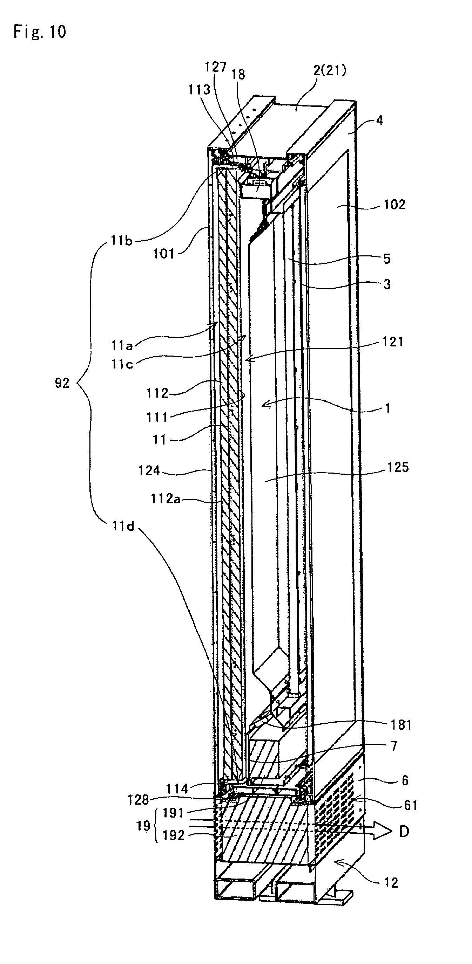

As shown in FIG.10 and FIG.11, the circulation path 92 surrounding the display panel 11 is formed inside the accommodation part 121. In FIG.10 and FIG.11, in order to clearly show the circulation path 92, an illustration of the heat pipes 13 and the heat collecting fins 17 is omitted (as in FIG.12 and FIG.13 as well, mentioned afterwards).

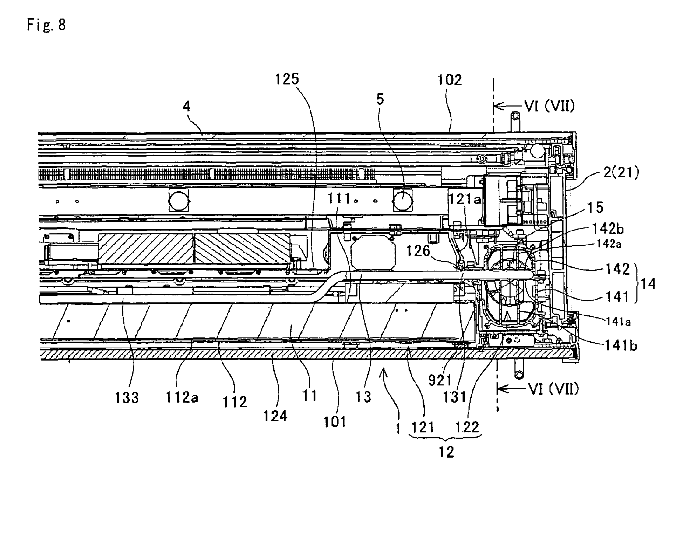

In this embodiment, a circulation path 92 is constituted by four path parts 11a to 11d. The path part 11a is formed between the surface wall 124 of the accommodation part 121, and the surface 112 of the display panel 11, and is extended along the surface 112 in a perpendicular direction. In detail, a pair of path formation components 921, 921 for forming the path part 11a is arranged on the surface 112 as shown in Fig.4. The pair of path formation components 921, 921 is extended along the surface 112 in a perpendicular direction and is intervened by the surface wall 124 and the surface 112 on both sides of the display screen 112a (see FIG.8). Thus, the path part 11a is formed, surrounded by the components 921,921, the surface wall 124, and the surface 112.

Additionally, as shown in FIG.12, a path part 11b is formed between the upper surface wall 127 of the accommodation part 121, and the upper end side 113 of the display panel 11. The path part 11c is formed between the back wall 125 and the back 111, and is extended along the back 111 in the perpendicular direction. The path part 11d is formed between the undersurface wall 128 and the lower end side as shown in FIG.13.

In this embodiment, the width W of the path part 11a (in the direction perpendicular to the outer surface of the display panel 11, see FIG.11) is smaller than that of the path part 11c. For example, the width W of the path part 11a is about 10 mm. Similarly, width W of the path parts 11b and 11d are about 10 mm.

The path parts 11a, 11b, 11c, 11d are annularly connected in order around the display panel 11, and surround the display panel 11. In other words, the path part 11a and the path part 11c are connected via path part 11b or path part 11d in the upper part or lower part respectively. The air in the circulation path 92 circulates through the surroundings of the display panel 11 by circulation fans 18 and 181 mentioned later. Therefore, the heat generated in the display screen 112a moves to the back 111 side.

### Aeration way

Inside the housing 12, the aeration ways 122 and 123 leading to the outside of the housing 12 is formed outside of the accommodation part 121. As shown in FIG.3, the aeration way 122 stretches along the side wall 121a, which is one side wall of the accommodation part 121 in the perpendicular direction, and the aeration way 123 stretches along the side wall 121b, a side wall of the another side. Hence, by forming the aeration ways 122 and 123 in both sides of the accommodation part 121, it can prevent the thickness of a display apparatus 1 being large.

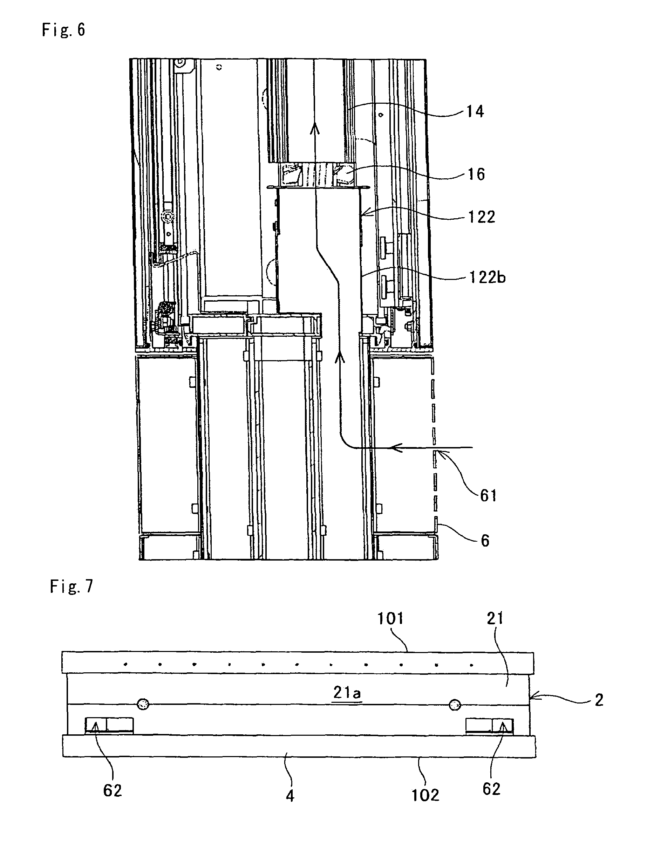

The upper end 122a of the aeration way 122 is bent in a cranked shape as shown in FIG.5, and it leads to the outside of the housing 12 through the vent 62 (see FIG.7) provided in the upper surface 21a of the frame part 21 of the support stand 2. It is as well for the upper end 123a of the aeration way 123. As shown in FIG.6, the lower end part 122b of the aeration way 122 leads to the outside of the housing 12 through the vent 61 of the aeration plates 6 which is installed under the display apparatus 1. The same applies to the lower end part 123b of the aeration way 123. Heat pipe 13

A plurality of heat pipes 13 are arranged in the path part 11c of the circulation path 92. As shown in FIG.3, a plurality of heat pipes 13 are fixed to the back 111, in a predetermined interval to perpendicular direction. In this embodiment, such heat pipes 13 are arranged on the both sides of the central line 111a of the back 111 in pairs.

As shown in FIG.8, a heat pipe 13 arranged at the aeration way 122 side of the central line 111a is extended from the back 111 of the display panel 11 to the aeration way 122, and penetrates a side wall 121a of the accommodation part 121, and is extended to the outside of the accommodation part 121. In detail, the heat pipe 13 is extended from the inside of the accommodation part 121 to the inside of the aeration way 122. In other words, the heat pipe 13 is arranged, protruding to the aeration way 122.

In detail, as shown in FIG.8, the penetration hole 126 is formed in the side wall 121a of the accommodation part 121, and the heat pipe 13 is stretched from the inside of the accommodation part 121 to the inside of the aeration way 122 via the penetration hole 126.

The heat pipe 13 arranged at the aeration way 123 side of the central line 111a stretches to the inside of the aeration way 123 from the inside of the accommodation part 121 (see FIG.4) via side wall 121b as well as a heat pipe 13 extended to the aeration way 122.

Further, as shown in Fig.8, the heat pipe 13 is thermally connected to the display panel 11, by contacting the back 111 of the panel 11, or via a heat conduction component. A part of the heat pipe 13, which does not contact to the panel 2, is covered by an insulation cover 133.

Thereby, heat from the display panel 11 can be collected directly from the back 111. Further, by covering the heat pipe 13 by the insulation cover 133, transmission of the heat of the heat pipe 13 to the air inside the accommodation part 121 is inhibited. Accordingly, the heat collected from the back 111 is efficiently transmitted outside the first accommodation part 121.

The heat emitted into the aeration way 122 and 123 from the heat pipe 13 is diffused outside the housing 12 via aeration ways 122 and 123. Hence, the aeration ways 122 and 123 function as heat collecting means which collect heat from the heat pipe 13. Accordingly, the rise in the temperature of the display panel 11 is prevented and the function of the liquid crystal display 10 can be maintained in a good state.

In this embodiment, since the heat pipes 13 are arranged at predetermined intervals at the back 111 of the display panel 11, heat can be collected from the whole path part, and can be collected from the whole back 111 side of a liquid crystal display. This enables the cooling efficiency of the display apparatus 1 to be high.

The temperature in the accommodation part 121 becomes higher than the temperate outside the accommodation part (i.e. aeration ways 122 and 123) when the display panel 11 generates heat. Additionally, coolant for heat exchange (e.g., fluid such as water) is placed inside the heat pipe 13. Therefore, from a view of raising the heat exchange efficiency of the heat pipe 13, it is desirable to arrange the heat pipes 13 so that they extend obliquely upward toward the aeration way 122 or 123 from inside of the accommodation part 121 as shown in FIG.3.

The heat pipe 13 in the outer side portion is arranged at a higher position than its inner side portion. By the heat from the display panel 11, the coolant in the inner side heat pipe 13 evaporates, and easily rises above toward the outer side. In the outer side portion, since the heat is deprived from the coolant by an air outside the accommodation part 121, the coolant is liquefied again and then falls back lower to inner side portion of the heat pipe 13. Then the coolant is evaporated again.

Thus, the coolant inside the heat pipe 13 circulates efficiently, and the heat exchange efficiency of the heat pipe 13 is raised. Accordingly, the heat from the panel 11 collected by the heat pipe 13 is efficiently emitted outside the first accommodation part 121.

Further, in this embodiment, since the heat pipe 13 is arranged at the back 111 of the display panel 11, restrictions when arranging the heat pipe 13 at the surface 112 side (i.e. inside the path part 11a) such as reduction of the display screen 112a, enlargement of a display apparatus 1, etc. are prevented. Thus, the heat exchange efficiency in the heat pipe 13 is high even if the heat pipe 13 is arranged at the back 111 because the heat generated by the display screen 112a is led to the heat pipe 13 by the air circulating through the circulation path 92.

Further, in order to raise a heat collecting efficiency from the back side 111 of the display panel 11, each of the heat pipes 13 is arranged along the back 111, as shown in Fig.4 and Fig.8.

Further, in this embodiment, the heat pipes 13 are repeatedly arranged in predetermined intervals in the perpendicular direction as shown in FIG.3, and are extended to the inside of the aeration way 122 or 123, maintaining the distance with the adjacent heat pipe 13 at the predetermined interval. Therefore, the heat collected by the heat pipe 13 can be dissipated in a distributed manner inside the aeration way 122 and 123, and as a result, the heat exchange (or heat dissipation) efficiency of the heat pipe 13 inside the aeration ways 122 and 123 can be increased.

### Air conditioner 19

The air conditioner 19 has an evaporator 191 and a condenser 192 as shown in FIG.2, FIG.9, FIG.10, and FIG.11. Moreover, the air conditioner 19 also has a compressor which is not illustrated. The evaporator 191 cools the air circulating through the circulation path 92 and returned to the air conditioner 19. The cooled air is again sent to the circulation path 92. The compressor compresses the coolant which flows inside the evaporator 191. The condenser 192 cools the coolant having a high temperature and pressure compressed by the compressor, and generates a liquefied coolant. When the liquefied coolant flows through the evaporator 191, the evaporator 191 can cool the surrounding air.

As shown in FIG.10 and FIG.11, the evaporator 191 is arranged at the back 111 side of the display panel 11 near the undersurface 114 of the display panel 11. In other words, the evaporator 191 is arranged at the lower end part of the path part 11c, in detail a front surface side of the portion 125b as shown in Fig.11.

By arranging the evaporator 191 at the back 111 side of the display apparatus 1, the display apparatus 1 does not need to be enlarged in the height direction. Further, by arranging the evaporator 191 to the back 111 side instead of the undersurface side 114 of the display panel 11, the circulation path 92 can be shortened.

The evaporator 191 may be arranged at the lower part of the display panel 11, i.e., the undersurface 114 side of the display panel 11 instead.

Further, as shown in FIG.13, the evaporator 191 is arranged near the portion 125b of the back wall 125. Thereby, the area near the lower end of the back wall 125 is cooled with the evaporator 191. Hereafter, the portion 125b is called a "cooled portion".

As shown in FIG.10 and FIG.11, the condenser 192 is arranged in the housing 12 and outside the accommodation part 121. Specifically, the condenser 192 is arranged between a pair of aeration plates 6, 6 under the accommodation part 121 (i.e., the lower part position of the display panel 11).

Moreover, between a pair of aeration plates 6, 6, an air intake and exhaust fan is stationed (not illustrated). This fan pulls air from the vent 61 formed in one of the aeration plate 6 and sends the air into the condenser 192 then discharges the air from the vent 61 in the aeration plate 6 of the other side. Thereby, the heat exhausted from the condenser 192 can be efficiently emitted outside the housing 12.

As shown by an arrow D in Fig.9, 10, 11 and 13, an air is inhaled from the vent 61 of the aeration plate 6 arranged in the front 101, and the air is emitted from the vent 61 of the aeration plate 6 arranged at the back 102.

According to the air conditioner 19, a heat generated from the display panel 11 is collected, and the temperature rise in display panel 11 is suppressed.

As a heat exchanging means for collecting a heat from the air inside the circulation path 92, other means may be used instead of the evaporator 191 and the condenser 192. Further, as a means for air intake and exhaust from the vent 61, other means may be used instead.

Furthermore, in this embodiment, the aeration plate 6 and the housing 12 are formed as different components, and the vent 61 is formed in the aeration plate 6. However, the vent 61 may be formed in the housing 12 without the aeration plate 6.

### Circulating fan 18,181

The circulating fans 18, 181 are fans for circulating the air in the circulation path. The circulating fan 18 is arranged at the back 111 side of the display panel 11, near the upper surface 113 of the display panel 11, as shown in FIG.10 and FIG.11. In other words, the circulating fan 18 is arranged at the upper end of the path part 11c of the circulation path 92. And the circulating fan 18 moves the air in the path part 11c to the lower portion, as shown in FIG.12.

The circulating fan 181 is arranged at the back 111 side of the display panel 11, and near the evaporator 191, in the accommodation part 121. In this embodiment, as shown in FIG.10 and FIG.11, the circulating fan 181 is arranged above the evaporator 191 in the lower end of the path part 11c, and sends an air towards the evaporator 191, as shown in FIG.13.

Thereby, the air in the circulation path 92 circulates around the display panel 11 in the direction of the solid line arrow, as shown in FIG.12 and FIG.13. Hence, by driving the circulating fan 18, 181, the air in the path part 11a can flow from the bottom up in the perpendicular direction, as shown in FIG. 12. The air then passes along the path part 11b, and flows into the path part 11c. Then the air flows downward along the path part 11c, as shown in FIG.13, and returns to the path part 11a through the path part 11d.

Since circulating air is sent to the evaporator 191 by the circulating fan 181 (see FIG.13), the air of the circulation path 92 can be sent to the evaporator 191 without stagnating in the path part 11c. Therefore, heat is efficiently collectable with the evaporator 191.

Further, in this embodiment, since the air of the path part 11a along the surface 112 of the display panel 11 flows from the bottom up, which corresponds to the natural direction of flow of warm air, the air in the path part 11a can flow upwards efficiently. Therefore, an air can easily circulate through the circulation path 92, and the heat generated in the display screen 112a of the display panel 11 can be led efficiently to the heat pipe 13 and the evaporator 191. As a result, the heat exchange efficiency or heat collecting efficiency at the heat pipes 13 and the evaporator 191 increase. Accordingly, the cooling efficiency of the display apparatus 1 increases.

Further, in this embodiment, since the circulating fan 18,181 are arranged at the back 111 side of the display panel 11, the display apparatus 1 does not have to be expanded in the height direction.

Although the circulating fans 18, 181 are used as a circulation means for circulating the air in the circulation path 92 in this embodiment, other circulation means may be adopted to accomplish the same function.

### Radiating fin 14

The radiating fin 14 is arranged in the aeration way 122, as shown in FIG.8, and is connected to the protrusion part 131 which protrudes into the aeration way 122 among the heat pipes 13. In this embodiment, the radiating fin 14 is formed by aluminum.

According to the above mentioned radiating fin 14, the heat dissipation efficiency from the heat pipe 13 to into the aeration way 122 and 123 increases, and, as a result, the cooling efficiency of the display apparatus 1 increases.

### Aeration fans 15 and 16

The aeration fans 15 and 16 are arranged in the aeration way 122, as shown in FIG.3. The aeration fan 15 is arranged at the upper end 122a of the aeration way 122, and the aeration fan 16 is arranged at the lower end 122b of the aeration way 122.

The aeration fans 15 and 16 pass the air in the aeration way 122 to the same direction along the aeration way 122. That is, the aeration fan 15 passes the air in the aeration way 122 from the bottom up, by emitting the air to the outside of the housing 12 from the vent, as shown in FIG.5. The aeration fan 16 passes the air in the aeration way 122 from the bottom up, by pulling the air outside of the housing 12 from the vent 61, as shown in FIG.6. In FIG.5 and FIG.6, the flow of the air is shown by the solid line arrows.

The aeration fans 15 and 16 are arranged in the aeration way 123 as well as in the aeration way 122 (see FIG.3), and these fans move the air in the aeration way 123 from the bottom up.

According to the above mentioned aeration fans 15 and 16, the heat emitted inside the aeration way 122 and 123 from the heat pipes 13 can be efficiently diffused outside of the housing 12. Therefore, the radiating efficiency of the heat pipe 13 and the radiating fin 14 are increased in the aeration way 122.

Further, in this embodiment, since the air in the aeration way 122 and 123 flows from the bottom up, the air can flow efficiently upwards since the warm air has a natural tendency for going up. Therefore, the heat emitted to the aeration way 122 and 123 can be efficiently diffused to the outside of the housing 12.

In this embodiment, though the aeration fans 15 and 16 are used as blowing means to exhaust the air in the aeration way 122 or 123 outside of the housing 12, other similar means may be adopted.

### Heat insulator 7

As shown in FIG.13, a heat insulator 7 is placed between the evaporator 191 and the display panel 11. In detail, the evaporator 191 is arranged at the back 111 side of the display panel 11, and the heat insulator 7 is arranged between the back 111 and the front 191a of the evaporator 191. A rubber material such as a silicon or urethane may be used as a material for the heat insulator 7.

As described above, the heat from the display panel 11 is transmitted to the evaporator 191 by an air flowing inside the circulation path 92, and is collected by the evaporator 191. According to the heat insulator 7, it can prevent an over cooling of the display panel 11 near the evaporator 191. Therefore, the temperature distribution of the display panel 11 can be uniformalized, and accordingly can keep the display panel 11 in good condition.

### Heat collecting fin 71, first blowing fan 72, and second blowing fan 73

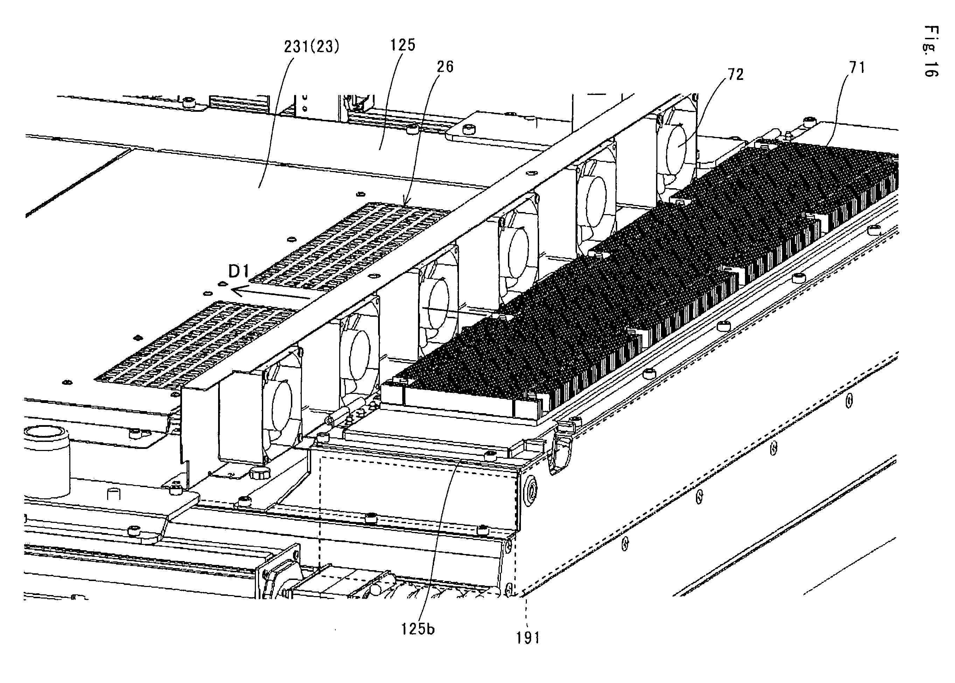

As shown in FIG.13 and FIG.16, a heat collecting fin 71 is arranged at the back side of the evaporator 191 among the back of the back wall 125. The heat collecting fin 71 functions as a heat collecting means, and it collects heat from the air in the back side of the back wall 125. Since the heat collecting fin 71 is arranged at the back side of the cooled portion 125b (which is at the back side of the evaporator 191), the heat collected by the heat collecting fin 71 is collected by the evaporator 191, and thereby the back side air of the cooled portion 125b is cooled efficiently.

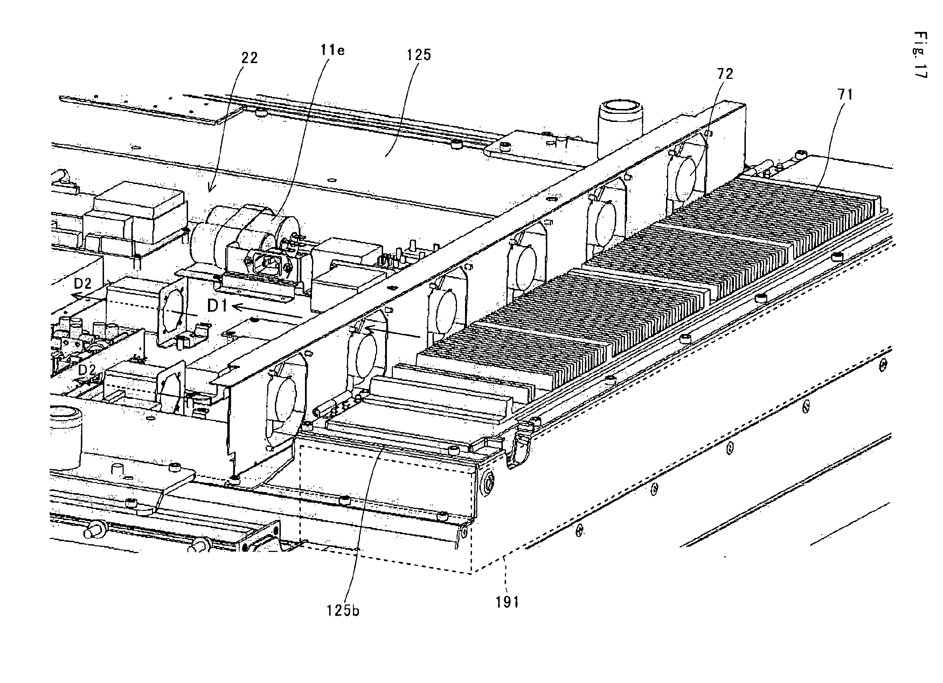

Further, as shown in FIG.13 and FIG.17, the first blowing fan 72 is arranged at the back of the back wall 125 near the upper part of the heat collecting fin 71. The first blowing fan 72 functions as a blowing means, and passes the air in the back side of the back wall 125 to the back side of the cover component 23 consisting the back wall of the second accommodation part 22. The first blowing fan 72 is arranged at the back side of the cooled part 125b and above the heat collecting fin 71. As shown by an arrow D1 of FIG.17, the first blowing fan 72 blows air up in the perpendicular direction.

Since the cooled portion 125b and the cover component 23 are aligned in substantially perpendicular direction (see Fig.11 and Fig.13), the air in the back side of the cooled portion 125b (i.e. the air cooled by the evaporator 191) is lead to the back side of the cover component 23 only by blowing the air in perpendicular direction by the first blowing fan 72.

By the air led to the back side of the cover component 23, theby the first blowing fan 72, the second accommodation part 22 is cooled from its back side. Therefore, the rise in heat of a circuit board 11e arranged in the second accommodation part 22 will be suppressed.

Further, in effort of the heat collecting fin 71, much cool air is can be led to the back side of the cover component 23, and thus the second accommodation part 22 is further cooled.

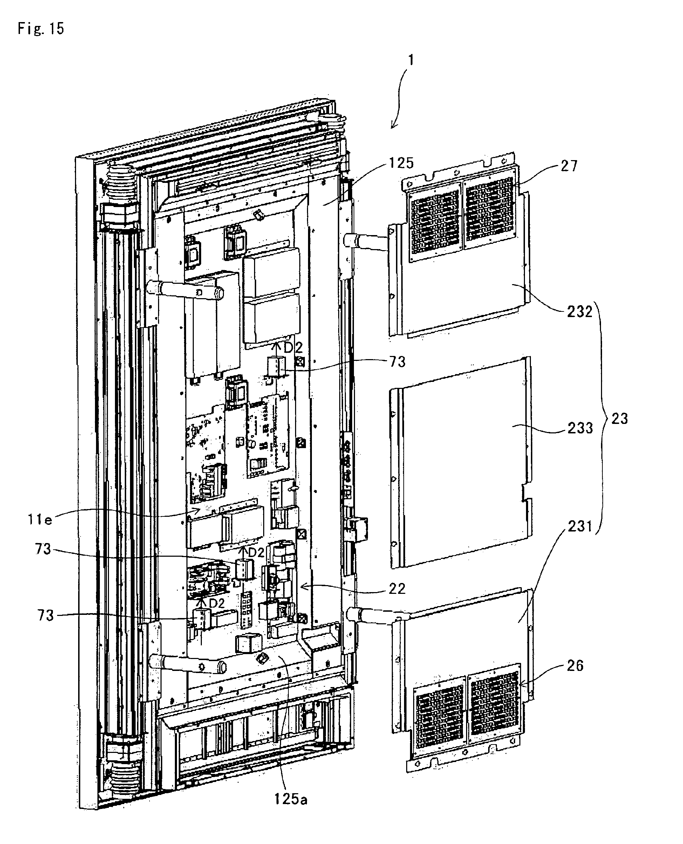

As shown in Fig.15 and Fig.17, the second blowing fan 73 is arranged at the back side of the back wall 125 of the second accommodation part 22. The second blowing fan 73 functions as a blowing means, and generates the flow of the air inside the second accommodation part 22.

As shown in Fig.15, three blowing fans 73 are arranged inside the second accommodation part 22, and all of the fans blow the air from the bottom up as shown in arrows D2 of Fig.15. Thereby, the air inside the accommodation part 22 can flow from the bottom up, as shown in Fig.11.

As mentioned above, ventilation openings 26 and 27 are formed in the lower part and the upper part cover component 23 respectively. By operating the second blowing fan 73, air in the second accommodation part 22 flows from the opening 26 to the opening 27 as shown in Fig.11.

Therefore, a cold air is inhaled from the opening 26, and the heat from the circuit board 11e is emitted from the opening 27.

Further, since the air cooled by the evaporator 191 is led to the back side of the cover component 23 by the first blowing fan 72, the cooled air is inhaled inside the second accommodation part 22 from the ventilation opening 26, and thus the circuit board 11e is cooled.

Therefore, according the heat collecting fin 71, the first blowing fan 72, and the second blowing fan 73, the temperature rise in the circuit board 11e is inhibited. Thus a heat trouble in the circuit board is reduced.

Although the heat collecting fin 71 is used as a heat collecting means, and blowing fans 72, 73 are used as blowing means for cooling the circuit board 11e, other means may be used instead.

Instead of leading the air in the back side of the cooled portion 125b to the back side of the cover component 23 by the first blowing fan 72 as described above (see Fig.16), the air in the back side of the cover component 23 may be lead to the back side of the portion 125b by the fan 72. In this case, the air inside the second accommodation part 22 is flown from the top down. Thereby, the heat from the circuit board 11e is led to the back side of the portion 125b and cooled by the heat collecting fin 71 and the evaporator 191.

Further, the first blowing fan 72 may be arranged under the heat collecting fin 71, instead of above the fin 71.

### 3. Modification

According to the display apparatus 1 mentioned above, the circulating fan 181 is arranged above the evaporator 191. Instead the circulating fan 181 may be arranged under the evaporator 191.

In this case, since the circulating fan 181 inhales air from the evaporator 191, the air is sent to the evaporator 191 from above. Thus, the heat can be collected efficiently by the evaporator 191.

The present invention is not limited to the foregoing embodiment but can be modified variously by one skilled in the art without departing from the spirit of the invention as set forth in the appended claims. For example, the technology mentioned above is applicable not only to the liquid crystal displays, but also to the other plane-surface type displays, such as plasma displays, or organic electroluminescence (Electro-Luminescence) displays.

## Claims

1. A display apparatus comprising:
a first accommodation part;
a display part arranged inside the first accommodation part, and is viewable from the front side of the first accommodation part;
a second accommodation part arranged at the back side of the first accommodation part;
a cooling unit arranged under the display part, which cools the display part;
a circuit unit arranged inside the second accommodation part and controls the display part, and
a fan leading an air from the cooling unit to the circuit unit.

2. A display apparatus comprising:
a first accommodation part;
a display part arranged inside the first accommodation part, and is viewable from the front side of the first accommodation part;
a second accommodation part arranged at the back side of the first accommodation part;
a circuit unit arranged inside the second accommodation part and controls the display part, and
an advertisement installation part which arranges the advertisement viewable from the rear side of the display apparatus,
wherein
the back wall of the second accommodation part is constituted by a removable cover component.

3. A display apparatus comprising:
a display part;
a circuit unit controlling the display part;
an accommodation part arranged at the back side of the display part and accommodates the circuit unit;
a cooling unit arranged under the accommodation part and cools the circuit unit;
a fan leading an air from the cooling unit to the accommodation part;
an upper side ventilation opening arranged at the back wall of the accommodation part, and
a lower side ventilation opening arranged at the back wall of the accommodation part and under the upper side ventilation opening.
